# NEUE EUROPÄISCHE PATENTSCHRIFT

(11) **EP 3 494 245 B2**
(45) Veröffentlichungstag und Bekanntmachung des Hinweises auf die Entscheidung über den Einspruch: **23.10.2024**
(45) Hinweis auf die Patenterteilung: 16.06.2021
(21) Anmeldenummer: 17752332.1
(22) Anmeldetag: 01.08.2017
(51) Int. Cl.: C23C 16/02, C23C 16/04, C23C 16/40, C23C 16/54

(54) **VERFAHREN ZUM BESCHICHTEN VON KUNSTSTOFFBEHÄLTERN**
METHOD FOR COATING PLASTIC RECEPTACLES
PROCÉDÉ DE REVÊTEMENT DE CONTENANTS PLASTIQUE

(30) Priorität: 02.08.2016 DE 102016114292
(43) Veröffentlichungstag der Anmeldung: 12.06.2019
(73) Patentinhaber: KHS GmbH, 44143 Dortmund (DE); KHS Corpoplast GmbH, 22145 Hamburg (DE)
(72) Erfinder: KYTZIA, Sebastian, 23826 Todesfelde (DE); KONRAD, Joachim, 40627 Düsseldorf (DE)
(74) Vertreter: Greiche, Albert
(86) Internationale Anmeldenummer: PCT/EP2017/069476
(87) Internationale Veröffentlichungsnummer: WO 2018/024747

(56) Entgegenhaltungen:
- EP-A1- 2 020 390
- WO-A1-2010/046072
- DE-A1- 102011 050 015
- DE-A1- 102011 050 016
- US-A1- 2009 280 268
- US-A1- 2009 284 421
- US-A1- 2009 304 950
- FRANK REINHOLD: "Innovation Pur", KHS COMPETENCE, 1 February 2014 (2014-02-01), XP055667306, Retrieved from the Internet <URL:https://competence.khs.com/022014-union-der-visionaere/innovation-pur/> [retrieved on 20200211]
- GAJDA JAROSLAW: "Innopet Plasmax-Beschichtungstechnologie. Qualitativ und ökonomisch klar im Vorteil", GETRÄNKE!, 1 March 2014 (2014-03-01), pages 22 - 26, XP055905927

## Beschreibung

Das Gebiet liegt in der Deposition einer SiOₓ-Beschichtung, insbesondere SiO₂-Bschichtung, die auf die Innenwand eines Kunststoffbehälters, wie z.B. einer leichten PET-Flasche aufgebracht wird. Durch den Depositionsprozess der Beschichtung, z.B. im Rahmen einer Plasmabeschichtung, insbesondere initiiert durch eine Entladungsreaktion, insbesondere eine so genannte Glimmentladung, wird der Kunststoffbehälter einer thermischen Belastung unterworfen, die zu einer Erhöhung der Temperatur des Kunststoffbehälters führt. Andererseits gibt es eine Obergrenze für die Temperatur des Kunststoffbehälters, die z.B. bei einer leichten PET-Flasche bei etwa 60-65°C liegt, oberhalb derer es zu einer dauerhaften plastische Verformung des Behälters führen kann.

Bei leichten PET-Flaschen ist der notwendige Energieeintrag durch den Depositionsprozess (SiOₓ-Beschichtung) begrenzt. Ziel der Aufbringung einer SiOₓ-Schicht ist die Bildung einer Diffusionsbarriere, die die Wanderung z.B. von Weichmachern des Kunststoffs in ein im Kunststoffbehälter befindliches Getränk verhindert oder zumindest stark vermindert. Um somit eine wirksame Barriere durch SiOₓ zu erhalten, ist ein hoher mittlerer Energieeintrag beim Depositionsprozess notwendig. Dieser Energieeintrag wird durch die Deposition von Ionen auf der PET-Wandung hervorgerufen und führt zu einer Erwärmung des Kunststoffbehälters. Der Transportmechanismus ist die ambipolare Diffusion. Je höher die kinetische Energie der Ionen auf die PET-Wandung ist, desto wirksamer und dichter wächst die SiOₓ-Schicht auf. Durch die Deposition wird letztendlich die kinetische Energie der Ionen in Wärme an der PET-Wandung umgesetzt. Der somit durch eine wirksame Barriere entstehende Temperatureintrag auf die PET-Wandung liegt typischer Weise bei ca. 30-35°C.

Die US 2009/304950 A1 schlägt vor, dass Behälter nach der Streckblasmaschine sinnvollerweise gekühlt werden, insbesondere wenn zusätzlich eine Sterilbehandlung mittels kaltem Plasma erfolgen soll. Die WO 2010/046072 A1 offenbart ganz allgemein eine Kühleinheit für Behälter am Neckring geführte Behälter nach einer Streckblasmaschine auf dem Weg zu einer Befüllungsvorrichtung und die EP 2 020 390 A1 zeigt ganz allgemein eine Vorrichtung zum luftgetriebenen Transport von am Neckring geführten Behältern. Frank Reinhold: "Innovation Pur", KHS competence, 1. Februar 2014 (2014-02-01)offenbart eine Beschichtungsanlage für PET Bierflaschen.

Problematisch ist es, wenn bei ungünstigen Rahmenbedingungen die oben genannte Grenztemperatur überschritten wird, wie z.B. in Regionen mit hohen Umgebungstemperaturen und/oder hoher Luftfeuchtigkeit.

Es ist daher Ziel der vorliegenden Erfindung, ein Verfahren zur Beschichtung von Kunststoffbehältern und eine Beschichtungsanlage zu schaffen, die eine zuverlässige Beschichtung der Kunststoffbehälter ohne deren Verformung ermöglicht.

Diese Aufgabe wird durch ein Verfahren gemäß Anspruch 1 und durch eine Beschichtungsanlage gemäß Anspruch 10 gelöst. Vorteilhafte Weiterbildungen der Erfindung sind Gegenstand der zugeordneten Unteransprüche. Vorteilhafte Ausbildungsformen der Erfindung sind ebenfalls in der Beschreibung und in den Zeichnungen beschrieben.

Bei dem erfindungsgemäßen Verfahren zum Beschichten von Kunststoffbehältern, nämlich PET-Flaschen mit einer SiOx-Beschichtung, wird die SiOx-Schicht, in der Regel eine SiO2-Schicht, unter Vakuum im Inneren des Behälters unter Bildung eines Plasmas abgeschieden. Die Plasmabildung erfolgt in der Regel unter Anwendung einer Entladungsreaktion, die dazu führt, dass sich SiO2-Partikel von der Oberfläche eines SiOx-haltigen Targets ablösen und an der Innenwand des Behälters anlagern. Durch die Tatsache, dass gemäß der Erfindung der Kunststoffbehälter unmittelbar vor der Beschichtung und/oder vor Einleitung eines Vakuums mittels einer Behälterkühlanlage, die eine Kühlgasvorrichtung aufweist, in der Beschichtungskammer gekühlt wird, wird erreicht, dass die anschließende Aufheizung des Kunststoffbehälters im Rahmen der Beschichtung, insbesondere Plasmaabscheidung durch die elektrische Entladung nicht zu einer plastischen Verformung des Kunststoffbehälters führt. So heizt sich erfindungsgemäß eine PET-Flasche im Rahmen der SiOx-Beschichtung durch das Plasma um 30 bis 35 Grad Celsius auf. Andererseits stellt eine Temperatur von etwa 60 bis 65 Grad eine Grenztemperatur für die Aufheizung des Kunststoffbehälters dar, die nicht überschritten werden sollte, da andernfalls eine bleibende Verformung des Kunststoffbehälters resultieren könnte. Indem der Kunststoffbehälter unmittelbar vor der Beschichtung heruntergekühlt wird, kann sichergestellt werden, dass der Kunststoffbehälter im Zuge der SiOx-Beschichtung eine Endtemperatur erreicht, die auf jeden Fall unterhalb der Grenztemperatur von 60 bis 65 Grad liegt. Somit ist die Endtemperatur, die im Rahmen der Beschichtung erreicht wird, unabhängig von den äußeren Umweltbedingungen, wie zum Beispiel hohen Umgebungstemperaturen oder eventuell einer hohen Umgebungsfeuchtigkeit.

Erfindungsgemäß wird der Behälter vorzugsweise auf eine Temperatur unter 30 Grad Celsius, insbesondere unter 28 Grad Celsius, heruntergekühlt, welche Anfangstemperatur zu Beginn des Beschichtungsvorgangs sicherstellt, dass die Endtemperatur nach dem Beschichtungsvorgang unterhalb von 60 Grad Celsius liegt.

Erfindungsgemäß erfolgt die Kühlung mit einem Gas, insbesondere mit Luft, als Kühlmedium, wobei die Kühlgasvorrichtung eine Vorrichtung zum Kühlen eines Kühlgases enthält. Ein Kühlgas lässt sich leicht in den Behälter einführen, zum Beispiel über in den Behälter eingeführte Zufuhrlanze. Andererseits lässt sich das Gas auch leicht in den Umgebungsraum um den Behälter einführen, so dass eine effektive Kühlung des Behälters sowohl von der Innenseite als auch von der Außenseite aus erfolgen kann. Vorzugsweise wird dem Kühlgas, insbesondere der Kühlluft, z.B. über eine Klimaanlage die Feuchtigkeit entzogen. Die dem Behälter zugeführte Kühlluft hat entsprechend vorzugsweise einen Feuchtigkeitsanteil von weniger als 30%, vorzugsweise weniger als 20%. Auf diese Weise wird erreicht, dass Restfeuchtigkeit aus der Umgebungsluft oder an der Behälterwandung von den Behältern entfernt wird, was die Qualität des nachfolgenden Beschichtungsvorgangs erheblich verbessert.

Vorzugsweise erfolgt die erfindungsgemäße Vorkonditionierung, insbesondere Vortemperierung des Kunststoffbehälters (PET-Flasche) im Einlauf der Beschichtungsanlage über eine definierte Wegstrecke, z.B. eine Luftförderstrecke, ein Transportband, oder dergleichen. Um die Vortemperierung der PET-Flaschen zu erhalten, ist die Auslegung der Klimatisierung zentral bedeutend, um keine Kondensation von Wasser auf der PET- Flasche zu erhalten. Dieses bedeutet, dass vorzugsweise mit hohen Luftströmen bei moderaten Temperaturen von 20 bis 30 Grad gekühlt wird, die nur geringfügig unter der Vorkonditionierungstemperatur von 28 bis 30 Grad liegen.

Des Weiteren wird/werden vorzugsweise die in der Beschichtungskammer vorgesehene(n) Behälteraufnahme(n), z.B. ein Beschichtungsrad, gekühlt, um eine Kondensation von Wasser an den Führungselementen der Beschichtungsanlage zu vermeiden.

Gemäß der Erfindung werden die Kunststoffbehälter vor/bei der Überleitung in die Beschichtungskammer der Beschichtungsanlage gekühlt, wobei die Kühlung (auch) in der Beschichtungskammer erfolgen kann. Vorzugsweise erfolgt die Kühlung des Behälters durch gekühlte Förderluft auf dem Transportpfad zur Beschichtungsanlage insbesondere in oder durch einen so genannten Lufttransport zur Beschichtungskammer. Vorteilhafterweise wird bei einem Lufttransport die Luft sowohl zur Förderung als auch zur Kühlung der Behälter verwendet. Weiterhin wird die Kühlluft bzw. das Kühlgas ganz allgemein bedarfsgemäß von Fremdstoffen, wie Staub befreit und im Feuchtegehalt eingestellt, durch entsprechende Gastrocknungseinheiten.

Die erfindungsgemäße Vorkonditionierung der PET-Flaschen und die Einspeisung der Kühlluft erfolgt vorzugsweise mit hohen Strömungsgeschwindigkeiten bzw. Volumenströmen und geringer Temperaturdifferenz zur Solltemperatur. Auf diese Weise kann eine Taupunktunterschreitung auf der Behälteroberfläche vermieden werden. Wenn z.B. die Solltemperatur zu Beginne des Beschichtungsvorgangs 30 Grad Celsius betragen soll, so wird vorzugsweise mit einer um maximal 10 Grad Celsius, insbesondere maximal 5 Grad Celsius niedrigeren Temperatur (verglichen zur Solltemperatur) gekühlt. Insbesondere kann vorzugsweise zur Kühlung des Behälters bzw. Behälterkörpers vor der Beschichtung die Kühlluft einer Maschinenkühlanlage (z.B. der Kühlanlage der Beschichtungsanlage) genutzt werden, so dass auf eine separate Kühlanalage für die Behälter verzichtet werden kann.

Im Umluftbetrieb erfolgt vorzugsweise eine Reduzierung des Frischluftbedarfs durch zumindest teilweise Einhausung der Kühlstrecke und/oder der Beschichtungskammer durch ein insbesondere gemeinsames Gehäuse. Auf diese Weise lassen sich die Kühl- und Klimatisierungsbedingungen vor der Beschichtung genau definieren und der Energieaufwand für die Kühlung wird reduziert.

Vorzugsweise werden die Kunststoffbehälter, insbesondere wenn sie als Kunststoffflaschen ausgebildet sind, im Bereich ihres Neck- bzw. Halsringes hängend geführt und durch einen Förderluftstrom durch einen sogenannten Luftförderer oder Air Conveyor bewegt. Vorzugsweise wird dieser Förderluftstrom gekühlt, so dass der Förderluftstrom gleichzeitig zum Kühlen der Flaschen verwendet wird. Der Luftstrom erfüllt somit in sehr ökonomischer Nutzung zwei Aufgaben gleichzeitig. Selbstverständlich kann jedoch der Kühlluftstrom vom Förderstrom auch entkoppelbar sein und/oder neben dem optional gekühlten Förderstrom wenigstens ein weiterer Kühlluftstrom zur Kühlung des Flascheninnenraums und/oder der Flaschenaußenwand vorgesehen sein.

Durch die Erfindung kann ein Kunststoffbehälter, z.B. eine leichte PET-Flasche mit einer wirksamen SiOₓ-Barriere bzw. SiOₓ-Schicht versehen werden.

Verfahrenstechnisch ist die Kühlung leicht zu realisieren, wenn die Kühlung innerhalb einer ummantelten Kühlstrecke vor einer Beschichtungskammer der Beschichtungsanlage erfolgt. Dies hat den Vorteil, dass innerhalb der Ummantelung gewünschte(n) Temperatur- und Feuchtigkeitsparameter eingestellt werden können, die dazu führen, dass zum einen eine Beschichtung ohne Beeinträchtigung durch Feuchtigkeit erfolgt, und zum anderen die Beschichtung aufgrund des Temperaturanstiegs des Behälters nicht zu einer Verformung des Behälters führt. Vorzugsweise wird auch die Beschichtungskammer durch das Kühlmedium, insbesondere das Kühlgas bzw. Kühlluft, gekühlt.

Erfindungsgemäß wird die Kühlstrecke als Transportstrecke der Behälter in die Beschichtungskammer genutzt. Auf diese Weise wird realisiert, dass der zur Beschichtungskammer notwendige Transport der Behälter kombiniert wird mit der Kühlstrecke, so dass der Transport und die Kühlung funktionell miteinander kombiniert werden können. Die Behälter können somit langsam heruntergekühlt werden, was die Gefahr einer Taupunktunterschreitung vermindert.

Hierbei können beispielsweise die Behälter auf einem Förderband angeordnet werden, wobei vorzugsweise im Bereich des Förderbandes eine Kühlvorrichtung angeordnet ist, so dass auch der Boden der Behälter gekühlt werden kann.

Vorzugsweise wird vor dem Beschichtungsvorgang insbesondere kontaktlos die Oberflächentemperatur des Behälters gemessen und die Kühlung wird in Abhängigkeit von diesem Messsignal gesteuert. Ergänzende kann insgesamt auch bedarfsweise eine gezielte Lufttrocknung und Feuchteabscheidung für die die Behälter umgebende Luft und/oder zugeführten Luftstrom vorgenommen werden. Dabei wird über den temperaturbedingten Gleichgewichtszustand hinaus eine Lufttrocknung und/oder Feuchteabscheidung vorgenommen, um Kondensatbildung auf dem Transportweg oder in der Beschichtungskammer sicher auszuschließen.

Auf diese Weise wird den Umgebungsparametern Rechnung getragen, denn wenn zum Beispiel die Umgebungstemperatur höher ist, führt dies auch dazu, dass die Temperatur der Flasche vor dem Beschichtungsvorgang höher ist. In diesem Fall wird die Leistung einer Kühlanlage hochgefahren, so dass die Temperatur der Flasche zu Beginn der Beschichtung auf einen konstanten Wert eingeregelt werden kann.

Vorzugsweise wird auch die Feuchtigkeit des Behälters und/oder der Umgebungsluft vor der Beschichtung durch einen Feuchtigkeitssensor ermittelt und eine Klimatisierungsvorrichtung der Kühlvorrichtung wird in entsprechender Weise gesteuert, um die Feuchtigkeit des Behälters/der Kühlluft zu Beginn des Beschichtungsvorgangs unterhalb eines gewünschten Grenzwertes zu halten.

Die Erfindung betrifft ebenfalls eine Beschichtungsanlage mit einer Beschichtungskammerfür eine SiOₓ-Beschichtung von Kunststoffbehältern, insbesondere PET-Flaschen. Die Beschichtungsanlage enthält eine Plasmaerzeugungsanlage und eine Beschichtungslanze zum Einbringen eines Beschichtungsmaterials in den Behälter, wobei die Plasmaerzeugungsanlage eine Energiezufuhr aufweist, um ein auf einem Target vorhandenes Beschichtungsmaterial in einen Plasmazustand zu überführen. Die im Plasma befindlichen Partikel setzen sich an der Innenwand des Behälters ab. Diese Energiezufuhr ist insbesondere eine elektrische Entladung.

Erfindungsgemäß ist in Verbindung mit der Beschichtungskammer eine Behälterkühlanlage oder -strecke angeordnet, so dass die Temperatur des Behälters zu Beginn des Beschichtungsvorgangs unterhalb einer gewünschten Grenztemperatur gehalten werden kann. Idealerweise schließt sich die Beschichtungskammer unmittelbar an die Behälterkühlanlage oder -strecke an. Auf diese Weise kann wirksam vermieden werden, dass sich der Behälter bei der Beschichtung infolge der damit einhergehenden Temperaturerhöhung verformt. Erfindungsgemäß umfasst die Behälterkühlanlage eine Kühlgasvorrichtung, insbesondere eine Kühlluftvorrichtung. Diese Kühlgasvorrichtung enthält eine Vorrichtung zum Kühlen des Kühlgases, eventuell eine Klimaanlage zum Entziehen der Feuchtigkeit aus dem Kühlgas, und Kühlgaszuführungseinrichtungen, um das Kühlgas einer Kühlstrecke der Behälterkühlanlage zuzuführen. Auf diese Weise kann der Behälter vor seiner SiOₓ-Beschichtung wirksam auf eine Temperatur heruntergekühlt werden, die eine Verformung während des/nach dem Beschichtungsvorgang ausschließt, auch wenn im Rahmen der Beschichtung eine Plasmaerzeugung mit hohem Energieeintrag in den Behälter erfolgt.

Vorzugsweise weist die Kühlgasvorrichtung wenigstens eine Gaszufuhrlanze zum Einführen in den Behälter auf. Auf diese Weise kann das Kühlgas sehr wirksam in den Innenraum des Behälters eingebracht werden, wo nachher die Abscheidung des SiOx-Materials im Rahmen der Plasmabeschichtung erfolgt, die eine Barriere gegen eine Diffusion vom Behälter in ein Getränk bildet.

Erfindungsgemäß sind die Beschichtungskammer der Beschichtungsanlage und eine Kühlstrecke der Behälterkühlanlage von einem miteinander verbundenen Gehäuse ummantelt, wobei bedarfsweise geeignete Übergabe- und Einteilelemente vorgesehen werden können, um die Behälter von der Kühlstrecke in die Beschichtungsanlage zu überführen oder diese Übergabe- und Einteilelemente sind ein Teil der Kühlstrecke Auf diese Weise kann sowohl in der Kühlstrecke als auch in der Beschichtungskammer durch die Behälterkühlanlage ein gewünschtes Temperaturprofil und Feuchtigkeitsprofil eingestellt werden.

Vorzugsweise ist die Behälterkühlanlage dazu ausgebildet, den Kühlgasdruck innerhalb des Gehäuses auf einem Druck über dem Umgebungsdruck zu halten. Auf diese Weise wird wirksam vermieden, dass wärmere Umgebungsluft oder feuchte Umgebungsluft in die Kühlstrecke der Behälterkühlanlage oder gar in die Beschichtungskammer hineingelangt. Im Gegenteil wird auf diese Weise wirksam erreicht, dass innerhalb der Kühlstrecke die durch die Behälterkühlanlage vorgegebene Atmosphäre vorherrscht, nämlich eine gewisse Höchsttemperatur und eine gewisse Höchstfeuchtigkeit.

Vorzugsweise enthält die Behälterkühlanlage eine Klimaanlage, um dem Kühlgas Feuchtigkeit zu entziehen, so dass der Bildung eines Feuchtigkeitsfilms auf dem Behälter beim Abkühlen entgegengenwirkt werden kann.

Vorzugsweise enthält die Beschichtungsanlage in der Beschichtungskammer oder unmittelbar vor der Beschichtungskammer einen Temperatursensor, um die Temperatur des Behälters vor dem Beschichtungsvorgang oder zu Beginn des Beschichtungsvorganges zu erfassen als auch eine Steuerung, die konzipiert ist, die Behälterkühlanlage in Abhängigkeit von dem Signal des Temperatursensors zu steuern. Auf diese Weise kann der Umgebungstemperatur wirksam Rechnung getragen werden. Bei höherer Umgebungstemperatur erfolgt eine stärkere Kühlung der Behälter und vice versa.

Vorzugsweise enthält die Beschichtungsanlage in der Beschichtungskammer oder unmittelbar vor der Beschichtungskammer einen Feuchtigkeitssensor, um die Feuchtigkeit an der Behälterwand oder in dem Kühlgas vor dem Beschichtungsvorgang oder zu Beginn des Beschichtungsvorganges zu erfassen, als auch eine Steuerung, die konzipiert ist, die Behälterkühlanlage, insbesondere den Feuchtigkeitsentzug des Kühlgases in Abhängigkeit von dem Signal des Feuchtigkeitssensors zu steuern.

Vorzugsweise enthält die Beschichtungsanlage eine Förderanlage zum Transportieren der Behälter in der Behälterkühlanlage, welche Förderanlage einen Förderluftstrom zum Transportieren der Behälter, insbesondere Flaschen erzeug, die dabei im Wesentlichen an ihrem Halsring geführt sind (siehe EP 2 020 390 A1). In der vorteilhaften Weiterbildung der Erfindung ist die Behälterkühlanlage mit der Förderanlage gekoppelt, um den Förderluftstrom zu kühlen. Auf diese Weise wird der Förderluftstrom zum Kühlen der Behälter verwendet, was eine kompakteren und effizientere Vorrichtung erlaubt.

Dabei ist es insgesamt vorteilhaft, dass beidseitig des Transportweges Seitenwände vorgesehen sind, so dass der kühlende Gasstrom an den transportierten Behältern herab sinkt. Idealerweise stellen die Seitenwände selbst Gasleitelemente dar, indem diese selbst als Gaskanal mit entsprechenden Auslässen ausgebildet sind oder Gasleitungen und/oder Düsenelemente sind an diesen angeordnet.

Vorteilhafterweise sind die Behälter auf der Kühlstrecke tunnelartig von vier Seiten umschlossen.

Es ist für den Fachmann offensichtlich, dass die oben genannten Ausführungsformen in beliebiger Weise miteinander kombiniert werden können. Folgende Begriffe werden synonym verwendet: Behälter - Kunststoffbehälter - Kunststoffflasche - PET - Flasche; SiOx-Schicht -SiOx-Barriere - SiOx-Beschichtung; Vorkonditionierung - Vortemperierung - Vorklimatisierung; Gas - Kühlgas - Kühlluft - Kühlmedium; Eingang - Behältereingang;

Die Erfindung wird nun beispielsweise anhand der schematischen Zeichnung beschrieben. In dieser zeigen:
Fig. 1 eine Beschichtungsanlage mit einer Behälterkühlanlage mit Förderband, und
Fig. 2 eine Beschichtungsanlage in Übereinstimmung mit Fig. 1 aber mit einer Luftförderung der Behälter in der Behälterkühlanlage.

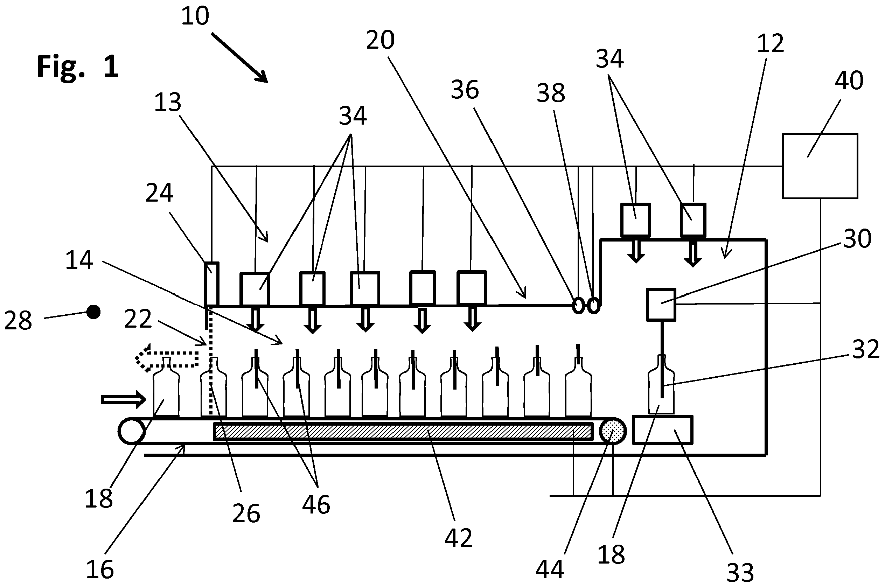

Fig. 1 zeigt eine Beschichtungsanlage 10 für Behälter 18, z.B. PET-Flaschen. Die Beschichtungsanlage 10 weist eine Beschichtungskammer 12 und eine unmittelbar davor angeordnete Behälterkühlanlage 13 mit einer Kühlstrecke 14 auf, in der ein Förderband 16 für die Behälter 18 angeordnet ist, so dass die Kühlstrecke 14 auch als Transportstrecke für die Behälter 18 fungiert. Die Behälterkühlanlage 13 und die Beschichtungskammer 12 sind von einem gemeinsamen Gehäuse 20 umgeben, das nur am Eingang 22 der Kühlstrecke 14 offen ist. An diesem Eingang ist vorzugsweise eine Gasdüsenanordnung 24 vorgesehen, um einen Gasmantel 26 zu erzeugen, der die Kühlstrecke 14 der Behälterkühlanlage 13 von der Umgebungsatmosphäre 28 trennt. Diese Gasdüsenanordnung 24 ist nicht unbedingt erforderlich, insbesondere wenn in der Beschichtungskammer 12 und/oder der Kühlstrecke 14 gegenüber der Umgebungsatmosphäre 28 ein Überdruck herrscht. In der Beschichtungskammer 12 ist eine Plasmaerzeugungsanlage 30 mit einer Plasmalanze 32 angeordnet, welche im Rahmen des Beschichtungsvorgangs in den Behälter 18 eingeführt wird. Der Behälter 16 wird in der Beschichtungskammer 12 mittels einer Behälteraufnahme 33 gehalten, die separat gekühlt sein kann.

Die Behälterkühlanlage 13 enthält eine Vielzahl von in der Kühlstrecke 14 angeordneten Kühlluftzuführungen 34. Derartige Kühlluftzuführungen 34 der Behälterkühlanlage 13 sind ebenfalls in der Beschichtungskammer angeordnet. Die Kühlluftzuführungseinrichtungen 34 können entweder jeweils oder insgesamt mit einer Kühleinrichtung versehen oder verbunden sein. Sie können weiterhin mit einer Klimaeinrichtung versehen/verbunden sein, mit welcher der eingeblasenen Kühlluft (siehe Pfeile) die Feuchtigkeit entzogen wird. Unmittelbar am Eingang der Beschichtungskammer 12 ist ein Temperatursensor 36 angeordnet, der die Temperatur des Behälters 26 unmittelbar vor dem Beschichten erfasst, z.B. ein IR-Sensor. Die Kühlluftzuführungen 34 als auch der Temperatursensor 36 und die Plasmaerzeugungseinrichtung 30 sind mit einer zentralen Steuerung 40 verbunden. Durch diese sind die Kühlluftzuführungen 34 hinsichtlich der Temperatur der abgegebenen Kühlluft in Abhängigkeit von dem Signal des Temperatursensors 36 regelbar. Zusätzlich kann ein Feuchtigkeitssensor 38 vorgesehen sein, der die Feuchtigkeit des Behälters 26 unmittelbar vor der Beschichtung erfasst. In Abhängigkeit vom Signal des Feuchtigkeitssensors lassen sich die in den Kühlluftzuführungen 34 angeordneten bzw. die mit den Kühlluftzuführungen 34 verbundene Klimaeinrichtung derart regeln, dass die zugeführte Kühlluft einen vorbestimmten maximalen Feuchtigkeitsgehalt aufweist, der dazu führt, dass ein Feuchtigkeitsgrenzwert für die Beschichtung der Behälter 18 auf jeden Fall unterschritten wird.

Innerhalb des Förderbandes 16 ist des Weiteren eine Kühlvorrichtung 42 der Behälterkühlanlage 13 vorgesehen, um die Behälterböden zu kühlen. Das Förderband 16 ist mittels eines Antriebsmotors 44 antreibbar. Sowohl die Kühlvorrichtung 42 als auch der Antriebsmotor 44 sind mit der Steuerung 40 verbunden, so dass die Steuerung 40 den gesamten Förder-, Kühl- und Beschichtungsvorgang steuert. Im Bereich der Kühlstrecke 14 sind mit einer Kühleinrichtung verbundene Kühlgaszufuhrlanzen 46 bewegbar angeordnet, welche (von oben) in die Behälter 18 eingeführt werden können, um durch diese Kühlluft vorbestimmter Temperatur und vorzugsweise auch vorbestimmter Feuchtigkeit zuzuführen, so dass sichergestellt werden kann, dass die Behälter 26 nicht nur von außen her gekühlt werden, sondern auch von der Innenseite her. Auf diese Weise wird erreicht, dass der Behälter 26 zu Beginn der Beschichtung insgesamt (von außen und innen) eine gewünschte Temperatur aufweist. Die Kühlluftzuführungen 34 werden durch die Steuerung 40 derart angesteuert, dass der Gasdruck in der Kühlstrecke 14 höher ist als in der Umgebungsatmosphäre 28, was dazu führt, dass durch den Gasmantel 26 kühlere Luft von der Kühlstrecke 14 entsprechend dem gestrichelt dargestellten Pfeil durch den Eingang 22 der Kühlstrecke 14 in die Umgebungsluft 28 entweicht. Auf diese Weise wird sichergestellt, dass niemals Luft aus der Umgebung mit einem eventuell höheren Temperatur- oder Feuchtigkeitsgehalt in die Kühlstrecke 14 eindringt. Durch die erfindungsgemäße Ausbildung der Beschichtungsanlage 10 wird sichergestellt, dass ein gewünschtes Beschichtungsergebnis mit hoher Qualität unabhängig von den in der Umgebungsatmosphäre vorliegenden Bedingungen, insbesondere Temperatur und Feuchtigkeit, erzielt wird. Eine derartige Anlage eignet sich daher insbesondere für Standorte, bei denen wechselnde Umweltbedingungen vorherrschen oder bei welchen hohe Temperaturen und/oder Feuchtigkeit vorherrschen.

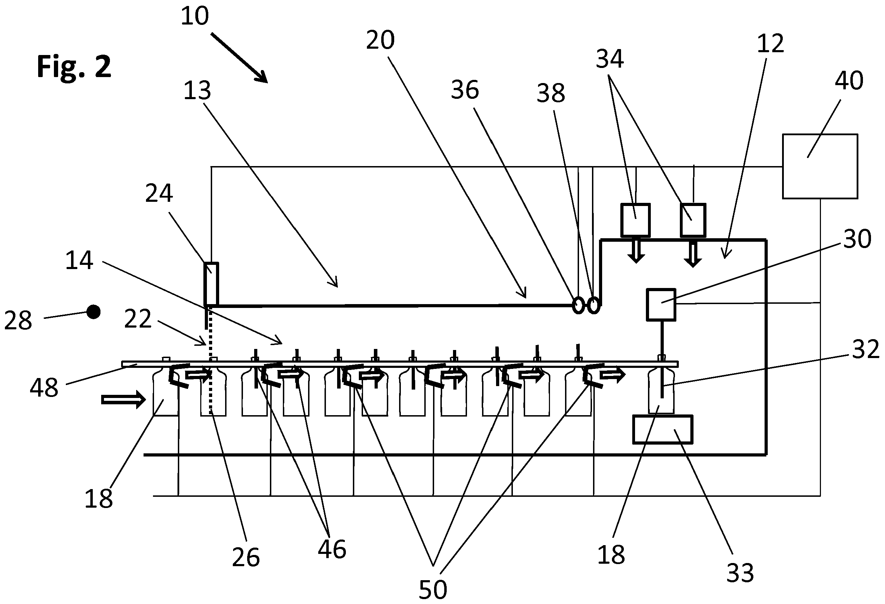

Die Ausführungsform der Fig. 2 unterscheidet sich von der Ausführungsform der Fig. 1 in der Ausbildung der Behälterkühlanlage 13. In Fig. 2 sind anstelle des Förderbandes 16 und der Kühlluftzuführungen 34 eine Fördervorrichtung bestehend aus einer Halsringführung 48, welche den Flaschenhals der Flaschen 18 führt und eine Luftförderanlage 50 vorgesehen, welche die Flaschen durch einen Luftstrom in Pfeilrichtung vorwärts in Richtung auf die Beschichtungskammer 12 fördert. Die Luftförderanlage 50 kann z.B. ausgebildet sein, wie es in der EP 2 020 390 beschreiben ist. Im Unterschied zu der dort gezeigten vorbekannten Luftförderanlage ist bei der Luftförderanlage 50 gemäß der vorliegenden Erfindung der Luftstrom gekühlt und trägt somit zur Kühlung der Kunststofflaschen 18 bei. Der Förderluftstrom ist dabei vorzugsweise im Gegensatz zur vorbekannten Vorrichtung so ausgereichtet, dass die gesamte Flasche angeblasen wird. Natürlich können in der Ausbildungsform der Figur 2 auch zusätzlich die Kühlluftzuführungen 34 aus Fig. 1 vorgesehen sein, z.B. um einen leichten Überdruck in der Kühlstrecke 14 zu erzeugen. Ebenfalls können in der Behälterkühlanlage die Kühlgaszufuhrlanzen 46 aus Fig. 1 zur Kühlung des Flascheninnenraums vorgesehen sein. Die Luftförderanlage 50 ist mit der zentralen Steuerung 40 verbunden, um so vorzugsweise in Abhängigkeit vom Signal des Temperatursensors 36 und eventuell des Feuchtigkeitssensors 38 angesteuert zu werden. Die Luftförderanlage 50 kann aus dezentralen Komponenten bestehen oder aus einer zusammenhängenden Luftführungseinrichtung, die sich entlang der Kühlstrecke erstreckt, und die mit einer gemeinsamen Kühl- und evtl. Klimaanlage verbunden ist.

Insgesamt gilt allgemein und für alle Ausführungsbeispiele, dass die Beschichtungskammer verschlossen werden kann, insbesondere um hierin ein Vakuum zu erzeugen. Weiterhin kann die Beschichtungskammer auf einem rotierenden Beschichtungsrad angeordnet sein und mit diesem im Produktionsprozess umlaufen. Dies ist insbesondere für Anlagen und Verfahren mit hohen Leistungen bekannt und vorteilhaft. Die gegebenenfalls hierfür erforderlichen Verschlusselemente, Schleusen sowie Transport- und/oder Überleitelemente sind vorliegend nicht dargestellt.

Die Erfindung ist nicht durch das oben beschriebene Ausführungsbeispiel begrenzt, sondern kann innerhalb des Schutzbereichs der nachfolgenden Ansprüche variiert werden.

### Bezugszeichenliste

- 10: Beschichtungsanlage
- 12: Beschichtungskammer
- 13: Behälterkühlanlage
- 14: Kühlstrecke
- 16: Förderband
- 18: Behälter - PET-Flasche
- 20: gemeinsames Gehäuse
- 22: Behältereingang der Kühlstrecke
- 24: Gasdüsenanordnung
- 26: Gasmantel
- 28: Umgebungsatmosphäre
- 30: Plasmaerzeugungsanlage
- 32: Plasmalanze
- 33: Behälteraufnahme
- 34: Kühllufterzeugungseinrichtungen - Kühlluftzuführungen
- 36: Temperatursensor
- 38: Feuchtigkeitssensor
- 40: Steuerung
- 42: Kühlvorrichtung des Förderbandes
- 44: Antriebsmotor
- 46: Kühlgaszufuhrlanze
- 48: Halsführungsschiene
- 50: Luftförderanlage mit gekühlter Förderluft.

## Patentansprüche

1. Verfahren zur Beschichtung von Kunstsoffbehältern (18), nämlich PET-Flaschen mit einer SiOx-Beschichtung, bei welchem Verfahren eine Deposition einer SiOx-Schicht im Inneren des Behälters unter Unterdruck und unter Bildung eines Plasmas erfolgt, wobei der Kunststoffbehälter sich im Rahmen der SiOx-Beschichtung durch das Plasma um 30 bis 35 Grad Celsius aufheizt, wobei der Kunststoffbehälter unmittelbar vor der Beschichtung mittels einer Behälterkühlanlage, die eine Kühlgasvorrichtung aufweist, gekühlt wird, **dadurch gekennzeichnet, dass** die Kühlung innerhalb einer ummantelten (20) Kühlstrecke (14) erfolgt und die Kühlstrecke (14) als Transportstrecke genutzt wird, wobei die Kühlgasvorrichtung eine Vorrichtung zum Kühlen eines Kühlgases enthält und die Kühlung der Behälter (18) mit dem gekühlten Kühlgas erfolgt, wobei der Behälter (18) auf eine Temperatur unter 30 Grad Celsius herunter gekühlt wird, wobei das Kühlgas eine um maximal 10 Grad Celsius niedrigere Temperatur aufweist.

2. Verfahren nach Anspruch 1, **dadurch gekennzeichnet, dass** der Behälter (18) auf eine Temperatur unter 28 Grad Celsius heruntergekühlt wird

3. Verfahren nach einem der vorhergehenden Ansprüche, **dadurch gekennzeichnet, dass** die Kühlung mit einem Kühlgas, nämlich Kühlluft als Kühlmedium erfolgt.

4. Verfahren nach Anspruch 3, **dadurch gekennzeichnet, dass** dem Kühlgas vor dem Beaufschlagen des Behälters (18) die Feuchtigkeit entzogen wird.

5. Verfahren nach Anspruch 3 oder 4, **dadurch gekennzeichnet, dass** das Kühlgas dem Innenraum des Behälters (18) über eine in den Behälter hineinragende Gaszufuhrlanze (46) zugeführt wird.

6. Verfahren nach einem der vorhergehenden Ansprüche, **dadurch gekennzeichnet, dass** die Außenwand des Behälters (18) gekühlt wird.

7. Verfahren nach einem der vorhergehenden Ansprüche, **dadurch gekennzeichnet, dass** vor der Beschichtung die Oberflächentemperatur des Behälters (18) gemessen (36) und das Messsignal für die Steuerung (40) der Kühlung der Behälter verwendet wird.

8. Verfahren nach einem der vorhergehenden Ansprüche, **dadurch gekennzeichnet, dass** vor der Beschichtung die Feuchtigkeit des Behälters (18) gemessen (38) und das Messsignal zur Steuerung des Feuchtigkeitsgehalts eines Kühlgases zur Kühlung der Behälter verwendet wird.

9. Verfahren nach einem der vorhergehenden Ansprüche, **dadurch gekennzeichnet, dass** die Behälter (18) mit wenigstens einem Förderluftstrom (50) gefördert werden, und dass der Förderluftstrom gekühlt wird.

10. Beschichtungsanlage mit einer Beschichtungskammer für eine SiOx-Beschichtung von Kunststoffbehältern (18), insbesondere PET-Flaschen, umfassend eine Plasmaerzeugungsanlage (30), und eine Beschichtungslanze (32) zum Einbringen eines Beschichtungsmaterials in den Behälter (18) und zur Energiezufuhr in das eingebrachte Beschichtungsmaterial, **dadurch gekennzeichnet, dass** in Verbindung mit der Beschichtungskammer (12) eine Behälterkühlanlage (13) angeordnet ist, wobei die Behälterkühlanlage (13) wenigstens eine Kühlgasvorrichtung, insbesondere Kühlluftzuführung (34) aufweist, wobei die Kühlgasvorrichtung eine Vorrichtung zum Kühlen eines für die Kühlung der Behälter vorgesehenen Kühlgases auf eine um maximal 10 Grad Celsius niedrigere Temperatur als eine Solltemperatur der Kunststoffbehälter am Beginn des Beschichtungsvorgangs enthält, wobei eine Beschichtungskammer (12) der Beschichtungsanlage und die Kühlstrecke der Behälterkühlanlage (13) von einem miteinander verbundenen Gehäuse (20) ummantelt sind.

11. Beschichtungsanlage nach Anspruch 10, **dadurch gekennzeichnet, dass** die Kühlgasvorrichtung wenigstens eine Kühlgaszufuhrlanze (46) zum Einführen in den Behälter (18) aufweist.

12. Beschichtungsanlage nach einem der Ansprüche 10 bis 11, **dadurch gekennzeichnet, dass** die Kühlstrecke der Behälterkühlanlage (13) als Lufttransportelement ausgebildet ist.

13. Beschichtungsanlage nach Anspruch 11 oder 12, **dadurch gekennzeichnet, dass** die Behälterkühlanlage (13) ausgebildet ist, den Kühlgasdruck innerhalb des Gehäuses auf einem Druck über dem Umgebungsdruck zu halten.

14. Beschichtungsanlage nach einem der Ansprüche 10 bis 13, **dadurch gekennzeichnet, dass** die Behälterkühlanlage (13) eine Klimaanlage zum Reduzieren des Feuchtigkeitsgehalts des Kühlgases aufweist.

15. Beschichtungsanlage nach einem der Ansprüche 10 bis 14, **dadurch gekennzeichnet, dass** sie eine Steuerung aufweist, die konzipiert ist, die Leistung der Behälterkühlanlage (13) in Abhängigkeit von dem Signal eines Temperatursensors der Beschichtungsanlage zu steuern.

16. Beschichtungsanlage nach einem der Ansprüche 10 bis 15, **dadurch gekennzeichnet, dass** in der Beschichtungskammer eine gekühlte Behälteraufnahme (33) für den Behälter (18) angeordnet ist.

17. Beschichtungsanlage nach einem der Ansprüche 10 bis 16, **dadurch gekennzeichnet, dass** eine Luftförderanlage (50) zum Transportieren der Behälter in der Behälterkühlanlage (13) ausgebildet ist, welche Luftförderanlage (50) einen Förderluftstrom erzeugt, und dass die Behälterkühlanlage (13) mit der Luftförderanlage (50) gekoppelt ist, um den Förderluftstrom zu kühlen.

## Claims

1. Method for coating plastic containers (18), namely PET bottles, with a SiOx coating, in which process a deposition of a SiOx layer is performed in the interior of the container under negative pressure and with the formation of a plasma, wherein the plastic container is heated by the plasma by 30 to 35 degrees Celsius as part of the SiOx coating process, wherein the plastic container is cooled immediately before the coating by means of a container cooling installation which has a cooling gas device, **characterized in that**
the cooling is performed within an enclosed (20) cooling section (14) and the cooling section (14) is used as a transport section, wherein the cooling gas device includes a device for cooling a cooling gas and the cooling of the container (18) is performed with the cooled cooling gas, wherein the container (18) is cooled down to a temperature below 30 degrees Celsius.

2. Method according to claim 1, **characterized in that** the container (18) is cooled down to a temperature below 28 degrees Celsius.

3. Method according to one of the preceding claims, **characterized in that** the cooling is performed with a cooling gas, namely cooling air as cooling medium.

4. Method according to claim 3, **characterized in that** the moisture is removed from the cooling gas before it is charged on the container (18).

5. Method according to claim 3 or 4, **characterized in that** the cooling gas is supplied to the interior of the container (18) via a gas supply lance (46) projecting into the container.

6. Method according to one of the preceding claims, **characterized in that** the outer wall of the container (18) is cooled.

7. Method according to one of the preceding claims, **characterized in that** the surface temperature of the container (18) is measured (36) before coating and the measurement signal is used for controlling (40) the cooling of the containers.

8. Method according to any one of the preceding claims, **characterized in that** before the coating the humidity of the container (18) is measured (38) and the measurement signal is used for controlling the humidity content of a cooling gas for cooling the containers.

9. Method according to one of the preceding claims, **characterized in that** the containers (18) are conveyed with at least one conveying air stream (50), and that the conveying air stream is cooled.

10. Coating installation with a coating chamber for SiOx coating of plastic containers (18), in particular PET bottles, comprising a plasma generation device (30), and a coating lance (32) for introducing a coating material into the container (18) and for supplying energy to the introduced coating material, **characterized in that** a container cooling installation (13) is arranged in connection with the coating chamber (12), wherein the container cooling installation (13) has at least one cooling gas device, in particular cooling air supply (34), wherein the cooling gas device contains a device for cooling a cooling gas provided for cooling the containers, wherein a coating chamber (12) of the coating installation and the cooling section of the container cooling installation (13) are enclosed by an interconnected housing (20).

11. Coating installation according to claim 10, **characterized in that** the cooling gas device comprises at least one cooling gas supply lance (46) for introduction into the container (18).

12. Coating installation according to any one of claims 10 to 11, **characterized in that** the cooling section of the container cooling installation (13) is designed as an air transport element.

13. Coating installation according to claim 11 or 12, **characterized in that** the container cooling installation (13) is configured to maintain the cooling gas pressure inside the housing at a pressure above the ambient pressure.

14. Coating installation according to any one of claims 10 to 13, **characterized in that** the container cooling installation (13) comprises an air conditioning device for reducing the moisture content of the cooling gas.

15. Coating installation according to one of the claims 10 to 14, **characterized in that** it comprises a controller being configured to control the output of the container cooling installation (13) as a function of the signal from a temperature sensor of the coating installation.

16. Coating installation according to one of the claims 10 to 15, **characterized in that** a cooled container receptacle (33) for the container (18) is arranged in the coating chamber.

17. Coating installation according to any one of claims 10 to 16, **characterized in that** an air conveyor device (50) is formed for transporting the containers in the container cooling installation (13), wherein the air conveyor device (50) generates a conveying air flow, and **in that** the container cooling installation (13) is coupled to the air conveyor device (50) for cooling the conveying air flow.

## Revendications

1. Procédé de revêtement des récipients en matière plastique (18), à savoir des bouteilles en PET, d'un revêtement de SiOx, procédé dans lequel une couche de SiOx est déposée a lieu à l'intérieur du récipient sous pression négative et avec formation d'un plasma, dans lequel le récipient en matière plastique se réchauffe de 30 à 35 degrés Celsius dans le cadre du revêtement SiOx par le plasma, le récipient en matière plastique étant refroidi immédiatement avant le revêtement au moyen d'une installation de refroidissement du récipient qui présente un dispositif de gaz de refroidissement, **caractérisé en ce que**
le refroidissement a lieu à l'intérieur d'une section de refroidissement (14) enfermée (20) et la section de refroidissement (14) est utilisée comme section de transport, dans laquelle le dispositif de gaz de refroidissement contient un dispositif pour refroidir un gaz de refroidissement et le refroidissement du récipient (18) a lieu avec le gaz de refroidissement refroidi, dans lequel le récipient (18) est refroidi à une température inférieure à 30 degrés Celsius.

2. Procédé selon la revendication 1, **caractérisé en ce que** le récipient (18) est refroidi à une température inférieure à 28 degrés Celsius.

3. Procédé selon l'une quelconque des revendications précédentes, **caractérisé en ce que** le refroidissement est effectué avec un gaz de refroidissement, à savoir de l'air de refroidissement comme milieu de refroidissement.

4. Procédé selon la revendication 3, **caractérisé en ce que** l'humidité est éliminée du gaz de refroidissement avant appliquer le gaz au récipient (18).

5. Procédé selon la revendication 3 ou 4, **caractérisé en ce que** le gaz de refroidissement est fourni à l'intérieur du récipient (18) par une lance d'alimentation en gaz (46) faisant saillie dans le récipient.

6. Procédé selon l'une quelconque des revendications précédentes, **caractérisé en ce qu'**on refroidit la paroi extérieure du récipient (18).

7. Procédé selon l'une quelconque des revendications précédentes, **caractérisé en ce que**, avant le revêtement, la température de surface du récipient (18) est mesurée (36) et le signal de mesure est utilisé pour contrôler (40) le refroidissement des récipients.

8. Procédé selon l'une quelconque des revendications précédentes, **caractérisé en ce qu'**avant le revêtement, l'humidité du récipient (18) est mesurée (38) et le signal de mesure est utilisé pour contrôler la teneur en humidité d'un gaz de refroidissement destiné à refroidir les récipients.

9. Procédé selon l'une quelconque des revendications précédentes, **caractérisé en ce que** les récipients (18) sont transportés avec au moins un courant d'air de transport (50), et **en ce que** le courant d'air de transport est refroidi.

10. Installation de revêtement avec une chambre de revêtement pour le revêtement de SiOx de récipients en plastique (18), en particulier de bouteilles en PET, comprenant une installation de génération de plasma (30), et une lance de revêtement (32) pour introduire un matériau de revêtement dans le récipient (18) et pour fournir de l'énergie au matériau de revêtement introduit, **caractérisée en ce qu'**une installation de refroidissement de récipient (13) est disposée en liaison avec la chambre de revêtement (12), l'installation de refroidissement de récipients (13) présente au moins un dispositif de gaz de refroidissement, en particulier une alimentation en air de refroidissement (34), le dispositif de gaz de refroidissement contenant un dispositif de refroidissement d'un gaz de refroidissement prévu pour le refroidissement des récipients, une chambre de revêtement (12) de l'installation de revêtement et la section de refroidissement de l'installation de refroidissement de récipients (13) étant enfermées par un boîtier (20) interconnecté.

11. Installation de revêtement selon la revendication 10, **caractérisée en ce que** le dispositif de gaz de refroidissement comprend au moins une lance d'alimentation en gaz de refroidissement (46) pour l'introduction dans le récipient (18) .

12. Installation de revêtement selon l'une quelconque des revendications 10 à 11, **caractérisée en ce que** la section de refroidissement de l'installation de refroidissement de récipients (13) est conçue comme un élément de transport d'air.

13. Installation de revêtement selon la revendication 11 ou 12, **caractérisée en ce que** l'installation de refroidissement de récipients (13) est adaptée pour maintenir la pression du gaz de refroidissement à l'intérieur du logement à une pression supérieure à la pression ambiante.

14. Installation de revêtement selon l'une quelconque des revendications 10 à 13, **caractérisée en ce que** l'installation de refroidissement de récipients (13) comprend un conditionneur d'air pour réduire la teneur en humidité du gaz de refroidissement.

15. Installation de revêtement selon l'une quelconque des revendications 10 à 14, **caractérisée en ce qu'**elle comprend un contrôleur conçu pour commander la sortie de l'installation de refroidissement de récipients (13) en fonction du signal d'un capteur de température de l'installation de revêtement.

16. Installation de revêtement selon l'une quelconque des revendications 10 à 15, **caractérisée en ce qu'**un réceptacle (33) refroidi pour le récipient (18) est disposé dans la chambre de revêtement.

17. Installation d'enrobage selon l'une quelconque des revendications 10 à 16, **caractérisée en ce qu'**un convoyeur à air (50) est disposé pour transporter les récipients dans l'installation de refroidissement de récipients (13), lequel convoyeur à air (50) génère un flux d'air de transport, et **en ce que** l'installation de refroidissement de récipients (13) est couplée au convoyeur à air (50) pour refroidir le flux d'air de transport.
